# EUROPEAN PATENT SPECIFICATION

(11) **EP 1 948 735 B1**
(45) Date of publication and mention of the grant of the patent: **26.01.2011**
(21) Application number: 06819255.8
(22) Date of filing: 06.11.2006
(51) Int. Cl.: C08L 63/00, C09J 163/00

(54) **FLAME RETARDANT PREPREGS AND LAMINATES FOR PRINTED CIRCUIT BOARDS**
FLAMMWIDRIGE PREPREGS UND LAMINATE FÜR LEITERPLATTEN
FEUILLES PREIMPREGNEES ET STRATIFIES IGNIFUGEANTS POUR CARTES A CIRCUIT IMPRIME

(30) Priority: 16.11.2005 US 737302 P
(43) Date of publication of application: 30.07.2008
(73) Proprietor: BASF SE, 67056 Ludwigshafen (DE)
(72) Inventor: KAPRINIDIS, Nikolas, New York, NY 10001 (US)
(74) Representative: Zumstein, Angela
(86) International application number: PCT/EP2006/068093
(87) International publication number: WO 2007/057311

(56) References cited:
- EP-A- 1 568 731
- JP-A- 57 133 147
- JP-A- 2005 154 511
- US-A- 5 684 071

## Description

This invention relates to prepreg and laminate compositions for use in forming printed circuit boards having excellent flame retardant properties, good thermal stability and thermal expansion characteristics, uniform appearance, low density and good drillability.

Printed circuit boards are produced by impregnating a fabric, such as an electronics grade fiber glass (E-glass) with a liquid thermosetting epoxy resin. The impregnated fabric is heated to partially cure the resin and to form a dry, flexible sheet in which the resin is in an intermediate cure state, sometimes referred to as the "B" stage or a "pre-preg" (prepreg). Prepreg sheets are then stacked together to a desired thickness and subjected to heat and pressure that fully cures the resin. This forms a laminated composite in which the resin is sometimes said to be in the "C"-stage.

Printed circuit boards consist of about 50% by weight epoxy resin and 50% by weight electronics grade fiber glass (E-glass). It is necessary that the prepregs and laminates have acceptable flame retardant properties. For example, the flame retardance standard for electronic compositions is the UL-94 V-0 rating.

*Published* U.S. app. No. 2004/0002559 teaches flame retardant coating formulations.

U.S. Pat. No. 6,632,511 teaches prepregs and laminates for printed circuit boards.

U.S. Pat. No. 6,255,371 teaches a flame retardant combination of organic phosphinates and condensation products of melamine with phosphoric acid.

U. S. Pat. No. 5, 739,187 discloses epoxy resin compositions as semiconductor encapsulants which include a certain phosphorus containing flame retardant to eliminate the use of antimony trioxide and brominated compounds.

U.S. Pat. No. 5,434,199 discloses a low stress epoxy molding composition which includes a tris-phenolmethane multifunctional epoxy resin in combination with a tris-phenolmethane multifunctional phenolic hardener, along with silicone rubber powder and an organofunctional silicone fluid. The organofunctional silicone fluid is provided to provide flowability to the molding compound.

U.S. published app. Nos. 2004/0166241 and 2004/0166325 teach electronic epoxy molding compositions comprising melamine cyanurate as a flame retardant.

It is desirable to provide flame retardant prepregs and laminates prepared with epoxy resins that meet UL-94 V-0 rating without halogenated flame retardants and without antimony compounds.

Subject matter of the invention is a prepreg or a laminate for a printed circuit board, which prepreg or laminate comprises
An epoxy resin and
A flame retardant combination comprising a fine particle size melamine cyanurate or a mixture of fine particle size melamine cyanurate and fine particle size melamine polyphosphate, where 99% of the particles have a diameter of less than or equal to 15 micron and a phosphinate and/or a diphosphinate having a formula as defined in claim 1.

The epoxy prepregs and laminates and the resultant coated circuit boards exhibit excellent flame retardancy as measured by UL-94, meeting V-0, have a uniform dielectric constant, good thermal stability and thermal expansion characteristics, uniform appearance, low density and good drillability.

U.S. published app. Nos. 2004/0166241 and 2004/0166325 teach electronic epoxy molding compositions comprising melamine cyanurate as a flame retardant.

There is no restriction on the type of epoxy resin that can be used in the prepregs and laminates of this invention. It generally contains two or more reactive oxirane groups. For example, the epoxy resin may be selected from bisphenol A type epoxy resins, novolac type epoxy resins such as epoxy cresol novolac resin and phenolic novolac epoxy resin, alicyclic epoxy resins, glycidyl type epoxy resins, biphenyl epoxy resins, naphthalene ring-containing epoxy resins, cyclopentadiene containing epoxy resins, polyfunctional epoxy resins, hydroquinone epoxy resins, and stilbene epoxy resins. The prepregs and laminates can include more than one epoxy resin, for example, a combination of epoxy cresol novolac resin and biphenyl epoxy resin.

Bisphenol and biphenyl epoxy resins, which are known as di-epoxies, and epoxy cresol novolac resins, which are known as multifunctional epoxies, are useful in the invention. Such epoxies have a degree of branching of two, in that two phenolic groups having pendant epoxies are linked through the same carbon atom. For example, diglycidyl ether of bisphenol A is difunctional, including two phenolic groups with pendant epoxies extending from a central carbon atom. It therefore has a degree of branching of two. Epoxy cresol novolac resins are often times referenced as "multifunctional", in that they are polymeric compounds with a plurality of pendant epoxy moieties which may extend from the polymeric chain. For example, epoxy cresol novolac resins include the following structure:

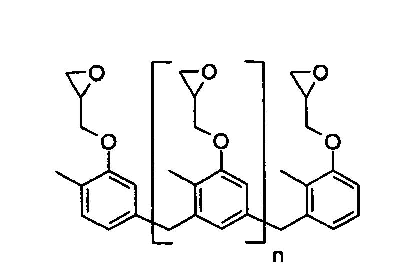

When n=0, the functionality if this structure is 2. If n=1, the functionality is 3; if n=4, the functionality is 4, etc. This compound is known as a multifunctional epoxy resin. Since only two phenolic groups extend from the same carbon or small cluster of carbons, the degree of branching of this type of resin is equal to two.

In a particularly desirable embodiment, the epoxy resin is a multifunctional epoxy resin having a degree of branching within the resin backbone of at least three. Thus, particularly desirable multifunctional epoxy resins are those derived from phenol and which include at least three phenolic groups branching directly from the same central carbon atom or central cluster of carbons, with a pendant oxirane group linked to each of the at least three phenolic groups.

Non-limiting examples of useful multifunctional epoxy resins having a degree of branching of at least three include:

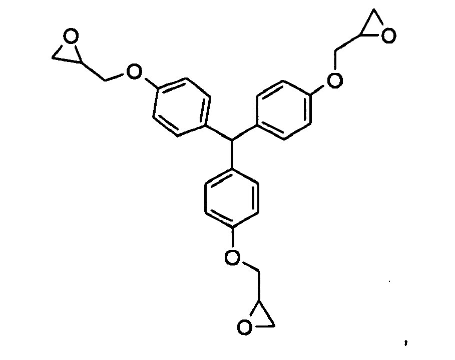

Triphenylol methane triglycidyl ether (having a degree of branching of three, represented by three terminal glycidyl ether moieties branching from a central carbon atom); 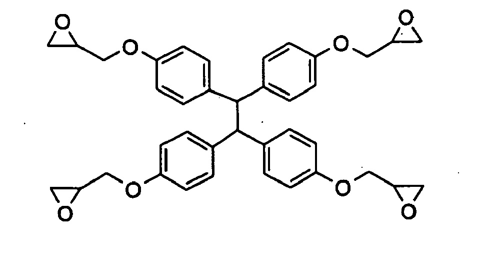 tetra glycidyl ether of tetra phenol ethane (having a degree of branching of four, represented by four terminal glycidyl ether moieties branching from a central two carbon cluster ethyl moiety).

Particularly desirable are epoxy resins derived from tris-phenolmethane, such as triphenylol methane triglycidyl ether.

The multifunctional resin having a degree of branching of at least three may be used alone, or in combination with conventional resins such as those described above.

The epoxy resin has a theoretical epoxy equivalent weight of about 150 to 250. The epoxy resin is for example present in the composition of the invention in an amount of about 1 to 25 percent by weight, often 4 to about 12 percent by weight, and more often, from about 5.5 to about 8.5 percent by weight, based on the total weight of the composition.

The prepregs and laminates contain a curing agent (hardener). The curing agent promotes crosslinking of the resin to form a polymer composition upon heating of the composition to a temperature of at least about 135°C. Some suitable curing agents that can be included in the invention are phenol novolac type hardener, cresol novolac type hardener, dicyclopentadiene phenol type hardener, limonene type hardener, and anhydrides. Flexible hardeners having a hydroxyl equivalent weight greater than about 150 are often desirable, such as xylock novolac type hardener. Non-limiting examples of flexible hardeners include bisphenol M commercially available from Borden Chemical, and DEH 85, commercially available from Dow Chemical. Similar to the epoxy resin component, more than one type of curing agent can be included in the compositions.

As with the epoxy resin component, multifunctional hardeners having a degree of branching of at least three are particularly desirable in one embodiment of the invention. Particularly desirable are those derived from tris-phenol and which contain at least three functional groups that are reactive with epoxide groups.

The curing agent is for example present in the composition of the invention in an amount of about 1 percent by weight to about 10 percent by weight, often from about 1.5 percent by weight to about 6 percent by weight, based on the total weight of the composition.

The composition may further include a catalyst for promoting reaction of the epoxy resin and the hardener. Such epoxy compositions incorporate catalysts such as tertiary amines, substituted phosphines, imidazoles, and the like, with compounds such as 1,8-diazabicyclo[5.4.0]undec-7-ene (DBU), dicyandiamide (DICY) and triphenylphosphine (TPP) being particularly well known for use as catalysts.

The catalyst is present at least in an amount sufficient to catalytically effect crosslinking of the epoxy resin and curing agent when the composition is heated to a temperature of at least about 135°C.

The epoxy resin may comprise a filler. The filler may be for example polymeric microspheres or traditional glass microspheres as disclosed in U.S. Pat. No. 6,632,511.

Other resins may be suitable for use in printed circuit board applications. For example, resins may comprise thermosetting resins such as epoxy, phenolic resin, benzoxazine, polyimide, cyanate ester, bismaleimide triazine, polyester, polyphenylene ether resins, polystyrene, polyphenylene oxide, polyphenylene sulfide, polysulfone, polyethersulfone, polyetherimide, polyacetal, polycarbonate and the co-polymers and blends thereof.

The resin may additionally comprise a variety of additives, individually or in the various combinations and permutations thereof. For example, the resin may optionally comprise an ultraviolet light blocking dye, a pigment, such as TiO₂ or Fe₂O₃, or resin to increase the opacity of the prepreg, laminate or printed circuit board to ultraviolet light. The resin may also optionally comprise a further flame retardant, for example, a halogen compound such as a brominated epoxy or brominated filler, or a halogen-free compound such as a phosphorus, nitrogen, or boron containing compound to increase the fire or flame-resistance. Preferably, no further flame retardants are employed. The resin may optionally comprise a surfactant such as Chemie BYK 322, an inorganic flow modifier such as hydrophobic fumed silica, and/or a thixotropy agent. These additive(s) will, in combination, comprise about 3.0 wt.% to about 20.0 wt.% of the resin. If the halogen substance is an epoxy resin, the bromine comprises about 15.0% to about 60.0% by weight of said resin, and about 5.0% to about 30.0% by weight of the total solid content. If the halogen substance is a filler, the bromine comprises about 20.0% to about 85.0% by weight of said filler, and about 5.0% to about 30% by weight of the total solid content.

Prepregs of the invention are formed by impregnating a reinforcing material with a varnish comprising (i) solvent and (ii) a polymeric resin, e.g. partially cured, or resin monomer. The reinforcing material selected generally depends upon the desired properties for the finished laminate. These include thickness, dielectric constant (DK), coefficient of thermal expansion ("CTE"), and the intended product application. In general, the reinforcing material may be a woven or non-woven mat comprising a fibrous material such as ceramic, glass, or polymeric fibers. Low dielectric constant materials such as electronics grade glass, D-glass, aramids such as Kevlar® and Nomex®, both registered trademarks of E.I. Dupont de Nemours and Company, poly p-phenylene benzobisthiazole, poly p-phenylene benzobisoxazole, polyetheretherketone, PTFE, aromatic polyesters, quartz, S-glass, paper, and the like, or combinations thereof may be used to form the mat of fibrous material. The reinforcing material may be in a cowoven or comingled form.

The laminates of the invention are prepared from prepregs using conventional techniques such as flat bed press or autoclave lamination. For example, prepreg sheets are sandwiched between two sheets of copper and laminated under heat and pressure (e.g. about 188°C) and 200-600 psi (about 13.75-40.0 Bar). Copper lines providing electrical pathways can be etched on to the resulting laminate. These can be used as a single substrate or pressed with other sheets of laminate, copper, and prepreg to produce a multi-layer laminate or printed circuit board.

The resulting laminate preferably has a relatively low dielectric constant. That is, the laminate preferably has a dielectric constant of less than 4.2 at 50% resin content. In some embodiments, the dielectric constant is preferably less than 3.9 at 50% resin content, more preferably less than 3.5 at 50.0% resin content, and may be no greater than 3.0 at 5.0% resin content.

Prepregs, laminates and printed circuit boards incorporating the flame retardants may be prepared in accordance with the invention with existing equipment and methods. For example, a prepreg is most often produced on treaters. The main components of a treater include feeder rollers, a resin impregnation tank, a treater oven, and receiver rollers. The reinforcing fabric (E-glass, for example) is rolled into a large spool. The spool is then put on the feeder rollers which turn and slowly roll out the glass. The glass then moves through the resin impregnation tank, which contains the varnish. The varnish wets out the glass. After emerging from the tank, the coated glass moves upward through the vertical treater oven which is at a temperature of about 350° to 400°F (about 175°C to 200°C), and the solvent of the varnish is boiled away. The resin begins to polymerize at this time. When the composite comes out of the tower it is sufficiently cured so that the web is not wet or tacky. The cure process is stopped short of completion so that additional curing can occur when laminate is made. The web then rolls the prepreg onto the receiver rolls which can be changed when the run is finished. A new roll is then attached to the treater so that a new run can begin.

The laminates prepared in accordance with the invention have good electrical properties such as a relatively low dielectric constant, good thermal properties such as higher decomposition temperature, good T-260 and T-288 properties, as well as good mechanical properties, such as thermal expansion characteristics (CTE and Z axis expansion). The prepreg and laminate prepared by this method also have good machinability, low density, and processability with the existing equipment/methods of prepreg manufacture.

This invention can be used with both passive and active components of printed circuit boards. The resulting prepreg and laminate have good electrical, thermal, mechanical, and processable properties as well as homogeneity in drilling and other printed circuit board machining operations.

The fine particle size melamine polyphosphate and melamine cyanurate flame retardants have a narrow particle size distribution. 99.0% of the particles have a diameter of less than or equal to 15.0 micron. For example, 99.0% of the particles have a diameter of less than or equal to 14.0 or 13.0 micron. For instance, 99.0% of the particles have a diameter of less than or equal to 12.0 micron. For instance, 50.0% of the particles have a diameter of from 3.0 to 3.5 micron.

Fine particle size melamine polyphosphate or melamine cyanurate is prepared from commercially available samples that are further milled by known methods.

The fine particle size melamine cyanurate, or combination of melamine cyanurate and melamine polyphosphate, in total, is present in the epoxy resin in a level of up to 20.0% by weight, based on the weight of the resin. For example, up to 17.0% by weight, or up to 15.0% by weight, based on the epoxy resin. For example, the melamine based flame retardants are present up to 13.0% by weight or for example from 9.0% to 13.0% by weight, based on the weight of the resin.

Phosphinate or diphosphinate or their combinations as flame retardants are also present, and they are generally present at about 1:1 weight ratios with the melamine based flame retardant(s). For example the phosphinate, diphosphinate or combination thereof is present from 1:10 to 10:1 by weight: weight, relative to the weight of the melamine based flame retardants. For example, the weight: weight ratios are from 1:5 to 5:1 or from 1:3 to 3:1.

The phosphinate or diphosphinate flame retardants are also for example present at a level of up to 20.0% by weight, based on the weight of the epoxy resin. For example, up to 17.0% by weight, or up to 15.0% by weight, based on the epoxy resin. For example, the phosphinate or diphosphinate based flame retardants are present up to 13.0% by weight or for example from 9.0% to 13.0% by weight, based on the weight of the resin.

The phosphinate or diphosphinate flame retardants are disclosed in U.S. Pat. No. 6,255,371.

The phosphinates or diphosphinates are of the formulae 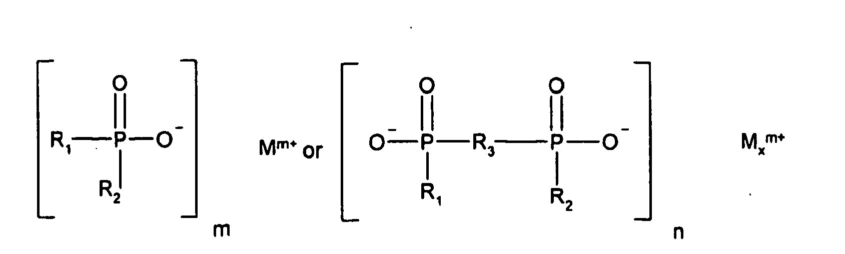 where
R₁ and R₂ are identical or different and are linear or branched C₁ -C₆alkyl or C₁-C₁₀aryl;
R₃ is linear or branched C₁ -C₁₀alkylene, C₆-C₁₀arylene, C₇-C₁₄alkylarylene or C₇-C₁₄arylalkylene;
M is magnesium, calcium, aluminum or zinc;
m is 2 or 3;
n is 1 or 3; and
x is 1 or 2.

Alkyl is for example methyl, ethyl, n-propyl, isopropyl, n-butyl, sec-butyl, t-butyl, n-pentyl or isoamyl.

C₆-C₁₀aryl is for example phenyl or naphthyl, but also comprised are C₁-C₄alkyl substituted phenyl.

Alkylaryl, is, for example, o-, m- or p-methylphenyl, 2,3-dimethylphenyl, 2,4-dimethylphenyl, 2,5-dimethylphenyl, 2,6-dimethylphenyl, 3,4-dimethylphenyl, 3,5-dimethylphenyl, 2-methyl-6-ethylphenyl, 4-tert-butylphenyl, 2-ethylphenyl or 2,6-diethylphenyl.

Arylalkyl is for example benzyl, α-methylbenzyl, α,α-dimethylbenzyl or
2-phenylethyl. For example benzyl and α,α-dimethylbenzyl.

Arylene, alkylarylene or arylalkylene are divalent versions of the monovalent aryl, arylalkyl or alkylaryl.

The following Examples illustrate the invention:
The prepregs and laminates and the resultant coated circuit boards exhibit a flammability rating of UL 94 V-1, more preferably, UL 94 V-0.

The ratings are determined by measuring the total burn time of a 1/8 inch bar according to the UL 94 V flammability test (Underwriters Laboratories UL 94, *Test for Flammability of Plastic Materials UL 94,* July, 1997). A UL 94 V-0 and a UL 94 V-1 rating require the total burn time for a single bar to be less than or equal to 10 seconds and 30 seconds, respectively. Ratings according to the UL 94 V test are as compiled in the following table:

| Rating | Burn time | Burning drips | Burn to clamp |
|---|---|---|---|
| V-0 | < 10 s | no | no |
| V-1 | < 30 s | no | no |
| V-2 | < 30 s | yes | no |
| Fail | < 30 s | | yes |
| Fail | > 30 s | | no |

### EXAMPLE

A varnish contains 190 g of epoxy cresol novolac resin, which is mixed with 0.5 g 2-methylimidazole in 3.6 g methyl ethyl ketone, and 7.2 g 1-methoxy-2-propanol. Also added are 12 weight% of fine particle size melamine cyanurate and 12 weight% of aluminum diethylphosphinate. The mixture is then well stirred for 4 hours, and applied to 7628 style E-glass fabric (supplied by BGF industries). The glass fabric is then brought to the partially cured B-stage by heating at 171°C for two and a half minutes. A four ply laminate is made, with size 1 oz. STD copper from Gould Foils Inc. on one side and 1 oz. DST copper Gould Foils Inc. on another side, by pressing the prepreg and copper in a book at 188°C and 140 psi for 90 minutes.The prepregs and laminates exhibit UL 94 rating of V-0.

The melamine cyanurate may be replaced with a mixture of melamine cyanurate and melamine polyphosphate. The particle size of each is where 99.0% of the particles have a diameter of less than or equal to about 12.0 micron, and about 50.0% of the particles have a diameter of from about 3.0 to about 3.5 micron.

The aluminum diethylphosphinate may be replaced with zinc diethylphosphinate. Excellent results are obtained.

## Claims

1. A prepreg or a laminate for a printed circuit board, which prepreg or laminate comprises
an epoxy resin,
a flame retardant which is a fine particle size melamine cyanurate or a mixture of fine particle size melamine cyanurate and fine particle size melamine polyphosphate, where 99% of the particles have a diameter of less than or equal to 15 micron, and
a phosphinate and/or diphosphinate flame retardant of the formulae 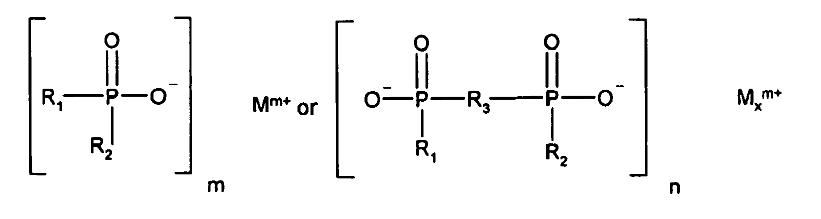 where
R₁ and R₂ are identical or different and are linear or branched C₁ -C₆alkyl or C₁-C₁₀aryl;
R₃ is linear or branched C₁-C₁₀alkylene, C₆-C₁₀arylene, C₇-C₁₄alkylarylene or C₇-C₁₄arylalkylene;
M is magnesium, calcium, aluminum or zinc;
m is 2 or 3;
n is 1 or 3; and
x is 1 or 2.

2. A prepreg or laminate according to claim 1, where 50% of the melamine cyanurate and melamine polyphosphate particles have a diameter of from 3.0 to 3.5 micron.

3. A prepreg or laminate according to claim 1, where the epoxy resin is selected from the group consisting of bisphenol A type epoxy resins, novolac type epoxy resins, alicyclic epoxy resins, glycidyl type epoxy resins, biphenyl type epoxy resins, naphthalene ring containing epoxy resins, cyclopentadiene containing epoxy resins, polyfunctional epoxy resins and combinations thereof.

4. A prepreg or laminate according to claim 1 further comprising a curing agent selected from the group consisting of phenol novolac type hardeners, cresol novolac type hardeners, dicyclopentadiene phenol type hardeners, limonene type hardeners, flexible type hardeners, anhydrides and combinations thereof.

5. A prepreg or laminate according to claim 1 where the melamine cyanurate and melamine polyphosphate flame retardants in total are present up to 20.0% by weight, based on the weight of the resin.

6. A prepreg or laminate according to claim 1 where the melamine cyanurate and melamine polyphosphate flame retardants in total are present from 9% to 13% by weight, based on the weight of the resin.

7. A prepreg or laminate according to claim 1 where the weight:weight ratio of phosphinate and diphosphinate flame retardants to the melamine cyanurate and melamine polyphosphate flame retardants is from 1:10 to 10:1.

8. A prepreg or laminate according to claim 1 where the phosphinate and/or diphosphinate is present up to 20% by weight, based on the weight of the resin.

9. A prepreg or laminate according to claim 1 where the phosphinate and/or diphosphinate is present from 9.0 % to 13.0% by weight, based on the weight of the resin.

## Patentansprüche

1. Prepreg oder Laminat für eine Leiterplatte, wobei das Prepreg oder Laminat
ein Epoxidharz,
ein Flammschutzmittel, bei dem es sich um ein feinteiliges Melamincyanurat oder eine Mischung von feinteiligem Melamincyanurat und feinteiligem Melaminpolyphosphat handelt, wobei 99% der Teilchen einen Durchmesser kleiner gleich 15 Mikron aufweisen, und
ein Phosphinat- und/oder Diphosphinat-Flammschutzmittel der Formeln 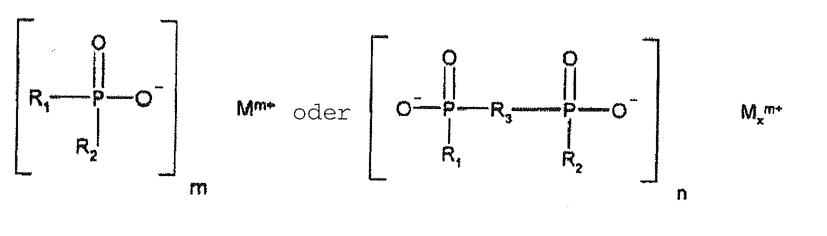 wobei
R₁ und R₂ gleich oder verschieden sind und für lineares oder verzweigtes C₁-C₆-Alkyl oder C₁-C₁₀-Aryl stehen;
R₃ für lineares oder verzweigtes C₁-C₁₀-Alkylen, C₆-C₁₀-Arylen, C₇-C₁₄-Alkylarylen oder C₇-C₁₄-Arylalkylen steht;
M für Magnesium, Calcium, Aluminium oder Zink steht;
m für 2 oder 3 steht;
n für 1 oder 3 steht und
x für 1 oder 2 steht;
umfaßt.

2. Prepreg oder Laminat nach Anspruch 1, wobei 50% der Melamincyanurat- und Melaminpolyphosphat-Teilchen einen Durchmesser von 3,0 bis 3,5 Mikron aufweisen.

3. Prepreg oder Laminat nach Anspruch 1, wobei das Epoxidharz aus der Gruppe bestehend aus Epoxidharzen vom Bisphenol-A-Typ, Epoxidharzen vom Novolak-Typ, alicyclischen Epoxidharzen, Epoxidharzen vom Glycidyl-Typ, Epoxidharzen vom Biphenyl-Typ, naphthalinringhaltigen Epoxidharzen, cyclopentadienhaltigen Epoxidharzen, polyfunktionellen Epoxidharzen und Kombinationen davon ausgewählt ist.

4. Prepreg oder Laminat nach Anspruch 1, das ferner einen Härter aus der Gruppe bestehend aus Härtern vom Phenol-Novolak-Typ, Härtern vom Kresol-Novolak-Typ, Härtern vom Dicyclopentadien-Phenol-Typ, Härtern vom Limonen-Typ, Härtern vom flexiblen Typ, Anhydriden und Kombinationen davon umfaßt.

5. Prepreg oder Laminat nach Anspruch 1, wobei die Melamincyanurat- und Melaminpolyphosphat-Flammschutzmittel insgesamt in einer Menge von bis zu 20 Gew.-%, bezogen auf das Gewicht des Harzes, vorliegen.

6. Prepreg oder Laminat nach Anspruch 1, wobei die Melamincyanurat- und Melaminpolyphosphat-Flammschutzmittel insgesamt in einer Menge von 9 bis 13 Gew.-%, bezogen auf das Gewicht des Harzes, vorliegen.

7. Prepreg oder Laminat nach Anspruch 1, wobei das Gewichtsverhältnis von Phosphinat- und Diphosphinat-Flammschutzmitteln zu Melamincyanurat- und Melaminpolyphosphat-Flammschutzmitteln 1:10 bis 10:1 beträgt.

8. Prepreg oder Laminat nach Anspruch 1, wobei das Phosphinat und/oder Diphosphinat in einer Menge von bis zu 20 Gew.-%, bezogen auf das Gewicht des Harzes, vorliegt.

9. Prepreg oder Laminat nach Anspruch 1, wobei das Phosphinat und/oder Diphosphinat in einer Menge von 9,0 bis 13,0 Gew.-%, bezogen auf das Gewicht des Harzes, vorliegt.

## Revendications

1. Préimprégné ou stratifié pour une carte de circuit imprimé, lequel préimprégné ou stratifié comprend une résine époxyde,
un ignifugeant qui est un cyanurate de mélamine ayant une fine taille des particules ou un mélange de cyanurate de mélamine ayant une fine taille des particules et de polyphosphate de mélamine ayant une fine taille des particules, où 99 % des particules ont un diamètre inférieur ou égal à 15 micromètres, et
un ignifugeant phosphinate et/ou diphosphinate représenté par les formules 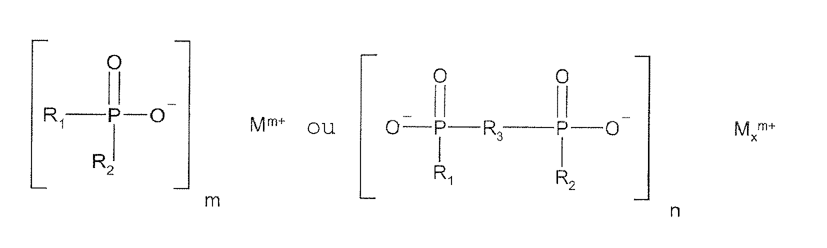 où
R₁ et R₂ sont identiques ou différents et sont un alkyle en C₁-C₆ linéaire ou ramifié ou un aryle en C₁-C₁₀ ;
R₃ est un alkylène en C₁-C₁₀ linéaire ou ramifié, un arylène en C₆-C₁₀, un alkylarylène en C₇-C₁₄ ou un arylalkylène en C₇-C₁₄ ;
M est le magnésium, le calcium, aluminium ou le zinc ;
n vaut 1 ou 3 ; et
x vaut 1 ou 2.

2. Préimprégné ou stratifié selon la revendication 1, où 50 % des particules de cyanurate de mélamine et de polyphosphate de mélamine ont un diamètre de 3,0 à 3,5 micromètres.

3. Préimprégné ou stratifié selon la revendication 1, où la résine époxyde est choisie dans le groupe constitué par les résines époxydes de type bisphénol A, les résines époxydes de type novolaque, les résines époxydes alicycliques, les résines époxydes de type glycidylique, les résines époxydes de type biphénylique, les résines époxydes contenant un noyau naphtalène, les résines époxydes contenant du cyclopentadiène, les résines époxydes polyfonctionnelles et les associations de celles-ci.

4. Préimprégné ou stratifié selon la revendication 1 comprenant en outre un agent durcisseur choisi dans le groupe constitué par les durcisseurs de type novolaque de phénol, les durcisseurs de type novolaque de crésol, les durcisseurs de type dicyclopentadiène-phénol, les durcisseurs de type limonène, les durcisseurs de type souple, les anhydrides et les associations de ceux-ci.

5. Préimprégné ou stratifié selon la revendication 1 où les ignifugeants cyanurate de mélamine et polyphosphate de mélamine sont présents au total en quantité allant jusqu'à 20,0 % en poids, sur la base du poids de la résine.

6. Préimprégné ou stratifié selon la revendication 1 où les ignifugeants cyanurate de mélamine et polyphosphate de mélamine sont présents au total en quantité de 9 % à 13 % en poids, sur la base du poids de la résine.

7. Préimprégné ou stratifié selon la revendication 1 où le rapport en poids:poids des ignifugeants phosphinate et diphosphinate sur les ignifugeants cyanurate de mélamine et polyphosphate de mélamine est de 1:10 à 10:1.

8. Préimprégné ou stratifié selon la revendication 1 où le phosphinate et/ou diphosphinate est présent en quantité allant jusqu'à 20 % en poids, sur la base du poids de la résine.

9. Préimprégné ou stratifié selon la revendication 1 où le phosphinate et/ou diphosphinate est présent en quantité de 9,0 % à 13,0 % en poids, sur la base du poids de la résine.
